# DEMANDE DE BREVET EUROPEEN

(11) **EP 1 333 106 A1**
(43) Date de publication de la demande: **06.08.2003**
(21) Numéro de dépôt: 02405065.0
(22) Date de dépôt: 01.02.2002
(51) Int. Cl.: C23C 14/06, C23C 14/35, C23C 14/34

(54) **Procédé et installation de dépot d'un revêtement noir sur un substrat**

(71) Demandeur: PX Techs S.A., 2304 La Chaux-de-Fonds (CH)
(72) Inventeur: Jaccard, Pierre E., 2014 Bôle (CH)
(74) Mandataire: Gresset, Jean

(57) **Abrégé**

L'invention concerne un procédé et une installation de dépôt d'un revêtement de couleur noire sur un substrat (48). L'installation comporte:
- une enceinte étanche (10) sous atmosphère de gaz inerte ,
- deux sources de pulvérisation cathodique (18H, 18B) disposées à l'intérieur de cette enceinte à proximité du substrat (48) et munies respectivement d'une cible en titane (30H) et d'une cible en aluminium (30B),
- des moyens d'alimentation desdites sources en tension électrique continue (38), et
- des moyens d'introduction d'azote (40H, 42H) et d'oxygène (40B-42B) dans l'enceinte entre les sources et le substrat.

## Description

La présente invention concerne un procédé et une installation de dépôt sur un substrat d'un revêtement décoratif de couleur noire.

Les couches décoratives, en particulier de couleur noire, sont très utilisées dans l'habillement horloger (élément de boîte ou de bracelet de montre), la bijouterie ou la joaillerie.

Un tel revêtement doit généralement être suffisamment opaque pour que la couleur du substrat n'affecte pas sa propre couleur noire. Il doit aussi très bien adhérer au substrat et résister à l'usure et la corrosion.

Le brevet CH 673 071 décrit un procédé de réalisation de ce type de revêtement. Celui-ci, appelé TIALON, est déposé par pulvérisation cathodique dans une atmosphère d'argon en utilisant une cible composite comportant du titane, de l'aluminium, de l'oxygène et de l'azote. Plus précisément, la cible est faite du mélange d'une poudre d'oxyde de titane et d'une poudre de nitrure d'aluminium qui est ensuite frittée. En variante, le mélange peut être celui d'une poudre de nitrure de titane et d'une poudre d'oxyde d'aluminium.

Un tel procédé est, certes, intéressant par sa simplicité. Il souffre cependant de plusieurs inconvénients qui rendent difficile son industrialisation. En effet, bien que la cible soit macroscopiquement conductrice de l'électricité, une tension continue ne suffit pas à entretenir la pulvérisation, ce qui oblige à lui superposer une tension alternative radio fréquence. L'alimentation électrique de l'installation s'en trouve ainsi compliquée et renchérie. Par ailleurs, le procédé nécessite typiquement près de quatre heures pour déposer 2 µm de couche décorative. Cette vitesse de dépôt est trop faible pour que le procédé soit économiquement rentable. Enfin, la cible proposée présente un fort risque de rupture car elle supporte mal les contraintes résultant de l'échauffement induit par la puissance électrique nécessaire au soutien de la pulvérisation cathodique.

La présente invention a pour but principal de fournir un procédé qui est exempt des inconvénients sus-mentionnés.

Pour atteindre ce but, le procédé selon l'invention consiste:
- à se munir d'une cible de titane et d'une cible d'aluminium, puis
- à effectuer simultanément une opération de pulvérisation cathodique à partir de chacune de ces cibles en présence du substrat à revêtir, dans une atmosphère de gaz réactifs et d'au moins un gaz inerte.

Le procédé comporte encore les principales caractéristiques avantageuses suivantes:
- la pulvérisation cathodique utilise la disposition magnétron;
- la pulvérisation est réalisée exclusivement sous une tension électrique continue;
- cette tension continue peut être pulsée avec inversion de polarité, de préférence à une fréquence comprise entre environ 20 et 250 kHz, avec un rapport cyclique compris entre environ 1 et 50%;
- les pressions partielles des gaz réactifs sont régulées de manière à maintenir les cibles dans l'état métallique;
- cette régulation des pressions partielles est réalisée à partir de la détection des émissions optiques caractéristiques des matériaux constituant les cibles et les gaz réactifs;
- les pulvérisations cathodiques sont faites de part et d'autre du substrat, lequel est entraîné en rotation de manière à leur être exposé alternativement;
- les gaz réactifs sont l'azote et l'oxygène.

La présente invention concerne également une installation pour la mise en oeuvre du procédé exposé ci-dessus. Cette installation comporte:
- une enceinte étanche sous atmosphère dudit gaz inerte,
- deux sources de pulvérisation cathodique disposées à l'intérieur de cette enceinte à proximité du substrat et munies respectivement d'une cible en titane et d'une cible en aluminium,
- des moyens d'alimentation desdites sources en tension électrique continue, et
- des moyens d'introduction d'azote et d'oxygène dans l'enceinte entre les sources et le substrat.

Une telle installation possède encore, de préférence, les caractéristiques suivantes:
- les deux sources se font face et des moyens sont prévus pour entraîner le substrat en rotation de manière à l'exposer alternativement à chaque source;
- les sources sont des sources magnétrons;
- elle comporte, en outre, des moyens pour réguler les pressions partielles d'azote et d'oxygène de manière à maintenir les cibles dans l'état métallique;
- les moyens d'alimentation sont agencés pour appliquer aux sources une tension continue pulsée avec inversion de polarité.

D'autres caractéristiques de l'invention ressortiront de la description qui va suivre, faite en regard du dessin annexé dans lequel:
- la figure 1 qui représente, vue en coupe axiale, une installation de dépôt d'un revêtement noir selon l'invention;
- la figure 2 est une vue schématique en perspective du porte-substrat, et
- la figure 3 représente les moyens utilisés pour contrôler la pression des gaz introduits dans l'installation.

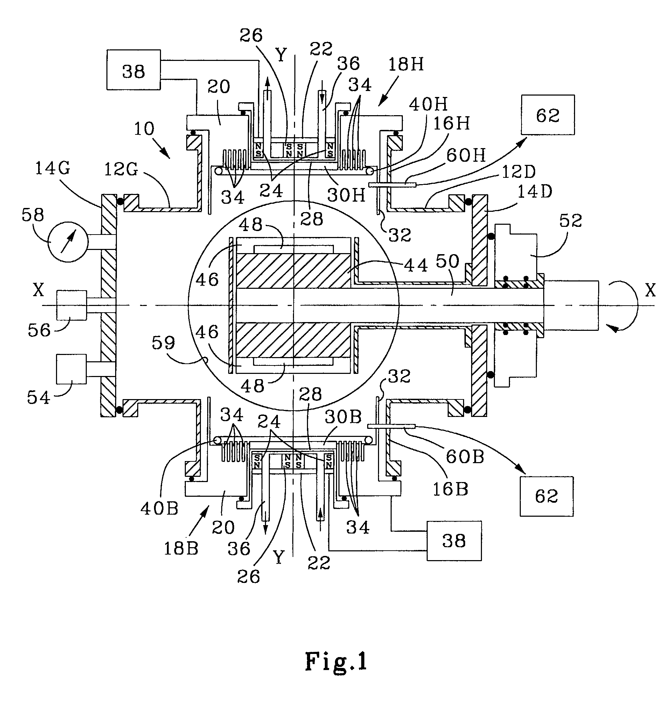

Sur la figure 1, on a représenté en 10 une enceinte en forme de croix, avantageusement réalisée en acier inox, dont les deux bras horizontaux 12 (axe X-X) sont obturés, à leurs extrémités, de manière étanche, par deux parois 14D - 14G. Les deux bras verticaux 16 (axe Y-Y) sont obturés, également de manière étanche, par deux dispositifs de pulvérisation cathodique circulaires en configuration magnétron 18H - 18B.

Ces deux dispositifs comportent une anode annulaire 20 coaxiale à Y-Y et, disposée à l'intérieur de l'anode, coaxialement à elle, une cathode cylindrique 22 qui contient un aimant annulaire 24 et un aimant cylindrique central 26 séparés l'un de l'autre et disposés de manière à ce que leurs pôles soient inversés. Typiquement, l'anode 20 est en acier inox ou en aluminium et la cathode 22 en cuivre.

Les faces internes 28 des deux cathodes 22 portent une cible 30 formée d'un disque métallique. Dans l'exemple décrit, la cible 30H de la source magnétron supérieure 18H est en titane pur (>99.8%) alors que la cible 30B de la source magnétron inférieure 18B est en aluminium pur (>99.99%).

On remarquera, par ailleurs, que l'anode 20 se prolonge, vers l'intérieur, par une paroi 32 et que sa face interne, située au même niveau que celle de la cible 30, est entaillée d'un réseau de rainures concentriques 34. On notera aussi que la cathode 22 est traversée par un circuit d'eau de refroidissement 36. Enfin, l'anode 20 et la cathode 22 de chacun des dispositifs 18 sont reliées à une source de tension continue 38. Typiquement, la tension peut être comprise entre -200 et -800 Volts.

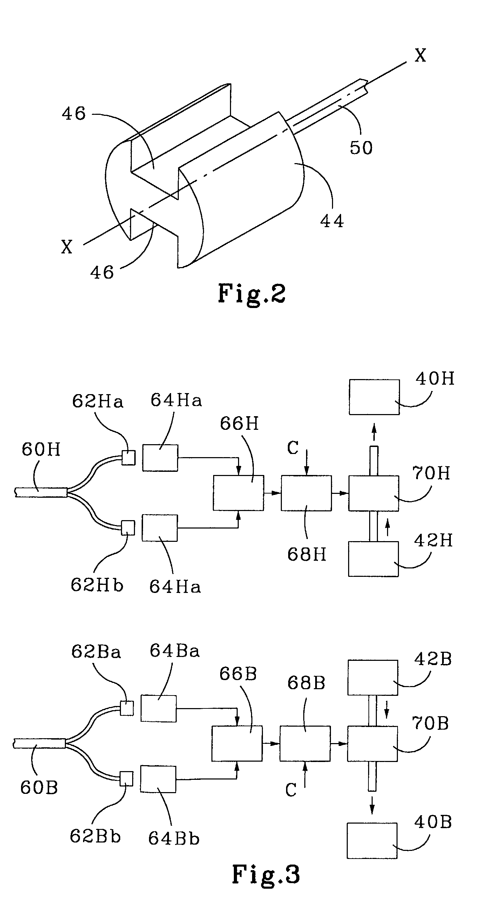

Chacune des sources magnétrons 18 est associée à un tube annulaire 40 percé d'une pluralité de petits orifices et disposé à proximité de la face interne de l'anode 20. L'anneau 40H est relié à une source d'azote 42H, tandis que l'anneau 40B est relié à une source d'oxygène 42B. Ces deux sources sont visibles uniquement sur la figure 3.

Le centre de l'enceinte 10 est occupé par un porte-substrat rotatif 44, avantageusement réalisé en cuivre ou en aluminium et représenté schématiquement en perspective sur la figure 2. Il est de forme sensiblement cylindrique, coaxial à X-X, mais présente deux rainures 46 diamétralement opposées formant des logements dans lesquels sont disposés deux substrats 48 (visibles seulement sur la figure 1) devant recevoir un revêtement noir. Le porte-substrat 44 est fixé à un arbre horizontal 50 traversant la paroi 14D puis un corps 52 garantissant l'étanchéité et facilitant la rotation, avant d'aboutir à un moteur (non représenté) permettant de l'entraîner en rotation, typiquement à une vitesse de 30 à 600 tours par minute.

La paroi opposée 14G est percée d'orifices servant à relier l'enceinte 10 respectivement à une pompe à vide primaire 54, à une source 56 de gaz non réactif, tel que l'argon, sous une pression de 0.5 à 5 Pa environ et à une jauge à vide 58. Par ailleurs, la paroi arrière de l'enceinte comporte une ouverture 59 qui permet de la relier à un conduit d'aspiration pour y établir un vide poussé.

En ligne de vue directe avec le plasma intense créé, ainsi que décrit plus loin, à la surface de la cible 30H par la source magnétron 18H, se trouve une double fibre optique 60H qui traverse la paroi de l'enceinte. Comme représenté sur la figure 3, chaque brin aboutit à un filtre interférentiel 62 précédant un détecteur de lumière 64. Le filtre 62Ha laisse passer la lumière caractéristique des atomes de titane alors que le filtre 62Hb laisse passer la lumière caractéristique de l'azote. Les signaux de sortie des détecteurs 64Ha et 64Hb aboutissent à un circuit diviseur 66H délivrant un signal représentatif du rapport des intensités des lignes caractéristiques des atomes d'azote provenant de l'anneau 40H et des atomes de titane provenant de la cible 30H. Ce signal est appliqué à un régulateur 68H, par exemple du type commercialisé sous la dénomination MKS 250E, agissant sur une vanne piezo-électrique 70H, par exemple du type commercialisé sous le dénomination Von Ardenne PCV25, pour contrôler le débit de l'azote que la source 42H fournit à l'anneau 40H.

De manière analogue à ce qui vient d'être décrit, en ligne de vue directe avec le plasma intense créé à la surface de la cible 30B par la source magnétron 18B, se trouve une double fibre optique 60B qui traverse la paroi de l'enceinte. Chaque brin aboutit à un filtre interférentiel 62 précédant un détecteur de lumière 64. Le filtre 62Ba laisse passer la lumière caractéristique des atomes d'aluminium alors que le filtre 62Bb laisse passer la lumière caractéristique de l'oxygène. Les signaux de sortie des détecteurs 64Ba et 64Bb aboutissent à un circuit diviseur 66B délivrant un signal représentatif du rapport des intensités des lignes caractéristiques des atomes d'oxygène provenant de l'anneau 40B et des atomes d'aluminium provenant de la cible 30B. Ce signal est appliqué à un régulateur 68B, identique au régulateur 68H, agissant sur une vanne piezo-électrique 70B, identique à la vanne 70H, pour contrôler le débit de l'oxygène que la source 42B fournit à l'anneau 40B.

En fonctionnement, les aimants 24 et 26 de chaque source magnétron circulaire 18 créent un champ magnétique qui est parallèle à sa cible 30 et sensiblement perpendiculaire, au voisinage de celle-ci, au champ électrique établi entre l'anode 20 et la cathode 22. Cette disposition des champs magnétique et électrique crée des conditions telles qu'il se forme, devant la cible en titane 30H, une zone de plasma de titane et d'azote et, devant la cible en aluminium 30B, une zone de plasma d'aluminium et d'oxygène. Du fait de la rotation du porte-substrat 44, ces deux plasmas produisent la pulvérisation en alternance sur les deux substrats 48 qui se recouvrent ainsi, de manière très homogène, d'un revêtement noir de titane, aluminium, oxygène et azote (TIALON).

Lors de la pulvérisation, le réseau de rainures 34 ménagées dans la face interne de l'anode 20, autour de la cible 30, rend difficile la neutralisation de l'anode par des dépôts de TiN ou d'Al₂O₃.

La disposition des champs adoptée dans le procédé selon l'invention piège les électrons accélérés du plasma, ce qui limite le bombardement des substrats, réduit leur échauffement et permet la présence sur les substrats d'épargnes par film photosensible en vue de la microstructuration du revêtement par une technique "lift-off". La disposition des champs permet aussi la création d'une zone de plasma très dense, ce qui assure un taux de dépôt élevé. De plus, l'utilisation d'une puissance électrique exclusivement DC simplifie considérablement l'alimentation de l'installation, le refroidissement des cibles par une circulation d'eau permettant l'application de puissances élevées et donc des vitesses de dépôt compatibles avec les exigences de rentabilité d'un procédé industriel. Typiquement, une couche de 2 à 3 µm peut être déposée en une heure seulement, soit environ quatre fois plus rapidement que la technique exposée dans le brevet CH déjà cité.

Il faut aussi noter que l'installation selon l'invention travaille dans des conditions de dépôt réactif grâce à la régulation des pressions partielles d'azote et d'oxygène. En effet, la surveillance de ces deux gaz, réalisée à partir des informations captées par les fibres optiques 60, permet aux régulateurs 68 d'agir sur les deux vannes 70 pour maintenir en permanence les pressions partielles d'azote et d'oxygène dans l'enceinte à des niveaux évitant l'empoisonnement des cibles 30H et 30B par des dépôts respectivement de TiN et d'Al₂O₃ résultant de réactions chimiques parasites entre les cibles et les gaz réactifs. Les niveaux de régulation des pressions partielles sont ajustés empiriquement en agissant sur la commande de consigne C des deux régulateurs 68. Les deux cibles sont ainsi maintenues dans leur état métallique, ce qui garantit le bon fonctionnement de l'installation.

Afin d'éviter les interférences des régulations des pressions partielles d'azote et d'oxygène, il peut être avantageux de prévoir, au milieu de l'enceinte 10, dans l'axe X-X, un écran horizontal (non représenté) ajouré pour laisser place au porte-substrat 44 et à l'arbre 50, qui isole physiquement l'un de l'autre les deux processus de pulvérisation cathodique.

Selon une variante de réalisation non représentée, les débits d'azote et d'oxygène peuvent rester fixes et ce sont alors les courants électriques d'alimentation des deux sources magnétrons 18 qui sont régulés de manière à éviter l'empoisonnement des cibles. Dans ce cas, des inversions de la polarité pendant de courts instants, typiquement entre +5 et +200 volts, permettent de neutraliser les charges électriques qui s'accumulent sur les parties des cibles ayant réagi avec les gaz. L'emploi de tensions pulsées de fréquence comprise entre environ 20 et 250 kHz et d'un rapport cyclique pour l'inversion de polarité compris entre environ 1 et 50% améliore fortement la stabilité du procédé.

Enfin, il peut être avantageux d'appliquer au porte-substrat 44 une tension électrique de polarisation qui assure une densification des couches de TIALON obtenues.

## Revendications

1. Procédé de dépôt d'un revêtement de couleur noire sur un substrat (48), **caractérisé en ce qu'**il consiste:
- à se munir d'une cible de titane (30H) et d'une cible d'aluminium (30B), et
- à effectuer simultanément une opération de pulvérisation cathodique à partir de chacune de ces cibles en présence dudit substrat dans une atmosphère de gaz réactifs et d'au moins un gaz inerte.

2. Procédé selon la revendication 1, **caractérisé en ce que** la pulvérisation utilise la disposition magnétron.

3. Procédé selon l'une des revendications 1 et 2, **caractérisé en ce que** la pulvérisation est réalisée exclusivement sous une tension électrique continue.

4. Procédé selon la revendication 3, **caractérisé en ce que** la tension électrique est pulsée avec inversion de polarité.

5. Procédé selon la revendication 4, **caractérisé en ce que** la pulsation se fait à une fréquence comprise entre environ 20 et 250 kHz, avec un rapport cyclique compris entre environ 1 et 50%.

6. Procédé selon l'une des revendications 1 à 5, **caractérisé en ce que** les pressions partielles des gaz réactifs sont régulées de manière à maintenir les cibles dans l'état métallique.

7. Procédé selon la revendication 6, **caractérisé en ce que** la régulation des pressions partielles est réalisée à partir de la détection des émissions optiques caractéristiques des matériaux constituant les cibles et les gaz réactifs.

8. Procédé selon l'une des revendications 1 à 7, **caractérisé en ce que** les pulvérisations cathodiques sont faites de part et d'autre du substrat, lequel est entraîné en rotation de manière à leur être exposé alternativement.

9. Procédé selon l'une des revendications 1 à 8, **caractérisé en ce que** les gaz réactifs sont l'azote et l'oxygène.

10. Installation pour la mise en oeuvre du procédé selon l'une des revendications 1 à 9, **caractérisée en ce qu'**elle comporte:
- une enceinte étanche (10) sous atmosphère dudit gaz inerte ,
- deux sources de pulvérisation cathodique (18H, 18B) disposées à l'intérieur de cette enceinte à proximité du substrat (48) et munies respectivement d'une cible en titane (30H) et d'une cible en aluminium (30B),
- des moyens d'alimentation desdites sources en tension électrique continue (38), et
- des moyens d'introduction d'azote (40H, 42H) et d'oxygène (40B-42B) dans l'enceinte entre lesdites sources et ledit substrat.

11. Installation selon la revendication 10, **caractérisée en ce que** les deux sources (18H, 18B) se font face et **en ce qu'**elle comporte des moyens pour entraîner le substrat en rotation (44, 50) de manière à l'exposer alternativement à chaque source.

12. Installation selon l'une des revendications 10 et 11, **caractérisée en ce que** lesdites sources sont des sources magnétrons.

13. Installation selon l'une des revendications 10 à 12, **caractérisée en ce qu'**elle comporte, en outre, des moyens pour réguler les pressions partielles d'azote (60H à 70H) et d'oxygène (60B à 70B) de manière à maintenir les cibles dans l'état métallique.

14. Installation selon l'une des revendications 10 à 13, **caractérisée en ce que** lesdits moyens d'alimentation sont agencés pour appliquer aux sources une tension continue pulsée avec inversion de polarité.
